# EUROPEAN PATENT APPLICATION

(11) **EP 4 822 737 A1**
(43) Date of publication of application: **14.10.2026**
(21) Application number: 23960756.7
(22) Date of filing: 05.12.2023
(51) Int. Cl.: H01L 21/02, G09F 9/33, G09F 9/00, H10H 20/857

(54) **TRANSFER METHOD, TRANSFER UNIT, METHOD FOR MANUFACTURING DISPLAY DEVICE, AND METHOD FOR MANUFACTURING MOUNTING BOARD**

(71) Applicant: SHIN-ETSU CHEMICAL CO., LTD., Tokyo 100-0005 (JP); Shin-Etsu Engineering Co., Ltd., Tokyo 101-0054 (JP)
(72) Inventor: OGAWA, Yoshinori, Tokyo 100-0005 (JP); KITAGAWA, Taichi, Annaka-shi, Gunma 379-0224 (JP); IKEDA, Tatsuhiko, Annaka-shi, Gunma 379-0224 (JP); SUNAGA, Seijiro, Tokyo 100-0005 (JP); SUZUKI, Tomoya, Annaka-shi, Gunma 379-0127 (JP); UEMORI, Nobutaka, Yokohama-shi, Kanagawa 234-0053 (JP); USAMI, Taketo, Yokohama-shi, Kanagawa 234-0053 (JP); YAMAOKA, Hiroshi, Yokohama-shi, Kanagawa 234-0053 (JP)
(74) Representative: Meissner Bolte Partnerschaft mbB
(86) International application number: PCT/JP2023/043506
(87) International publication number: WO 2025/120743

(57) **Abstract**

The present invention is a transfer method for transferring a structure to a transfer destination, the transfer method including: providing a release plate, the release plate including a base member, a resin layer provided on the base member and having a transmittance of 90% or more for a transfer laser, and a structure held on a surface of the resin layer opposite the base member; causing the transfer laser to enter the base member through a surface of the base member opposite the resin layer; and causing the transfer laser which entered to be transmitted through the base member and the resin layer and to thermally decompose at least a portion of the resin layer at an interface where the structure is in contact with the resin layer, thereby transferring the structure from the release plate to the transfer destination. Therefore, a transfer method capable of transferring a structure to a transfer destination with high accuracy can be provided.

## Description

### TECHNICAL FIELD

The present invention relates to a transfer method, a transfer unit, a method for manufacturing a display apparatus, and a method for manufacturing a mounted board.

### BACKGROUND ART

Recently, along with miniaturization of semiconductor devices, microstructure transfer (repositioning) technology using adhesive resin is attracting attention as a means of assembling electric and electrical application products using semiconductor devices. In particular, development of a technology for manufacturing LED displays for use in signage, TVs, medical applications, in-vehicle displays, smartphones, etc. is becoming active, which transfers (repositions) a large number, such as tens of thousands, of mini-LEDs (LED devices with a short side of 100 µm or more to several hundred µm) or micro LEDs (LED devices with a short side of 100 µm or less, further 50 µm or less) at once.

A method for repositioning microstructures, such as micro LEDs, using a silicone adhesive cured product as a donor substrate or a stamp material for transfer, and a method for mounting on a circuit board have been developed so far (for example, Patent Document 1).

Furthermore, a technology has also been proposed that mitigates impact during transfer, enabling a semiconductor chip to be transferred with high accuracy (for example, Patent Document 2).

### CITATION LIST

### PATENT LITERATURE

Patent Document 1: JP 2021-34610 A
Patent Document 2: JP 2019-67892 A1

### NON PATENT LITERATURE

Non Patent Document 1: Kristin M. Charipar, et al., "Use of an Elastomeric Donor for LIFT of Metal Foils", Journal of Laser Micro/Nanoenginerring, Vol. 13, No. 2, 2018.

### SUMMARY OF INVENTION

### TECHNICAL PROBLEM

Incidentally, a technology for transferring a structure using a laser may be exemplified by technologies in which an object to be transferred is repositioned by a laser-induced phenomenon such as laser ablation. Among such technologies, a technology in which an object to be transferred is moved in a laser irradiation direction is referred to as LIFT (Laser Induced Forward Transfer) (for example, Non Patent Document 1). Contrarily, a method in which an object to be transferred returns in the laser irradiation direction is referred to as LIBT (Laser-Induced Back Transfer).

In conventional LIFT, a release plate including a substrate and a holding layer formed on the substrate and holding a structure is used, and the structure is to be separated (transferred) from an interface between the substrate and the holding layer of release plate by laser ablation. Such a method makes it possible to transfer the structure to a transfer destination with a certain degree of accuracy.

However, in conventional LIFT, a slight change in laser irradiation energy density distribution for each pulse and a variation in energy density for each laser shot cause a change in the amount of gas generated during each transfer and within a laser-irradiated surface, which has an influence even on the flying-out direction and velocity of the structure. This influence imposes a limit on an improvement in transfer positional accuracy.

The present invention has been made to solve the above problem, and aims to provide: a transfer method capable of transferring a structure to a transfer destination with high accuracy; a transfer unit capable of transferring a structure to a transfer destination with high accuracy; a method for manufacturing a display apparatus capable of manufacturing a display apparatus in which structures are arranged on a wiring board with high accuracy; and a method for manufacturing a mounted board capable of manufacturing a mounted board in which structure are arranged on a wiring board with high accuracy.

### SOLUTION TO PROBLEM

To solve the above problem, the present invention provides a transfer method for transferring a structure to a transfer destination, the transfer method comprising:
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the transfer destination.

Such a transfer method of the present invention makes it possible to reduce a change in the amount of gas generated during each transfer and within a laser-irradiated surface to make the flying-out direction and velocity of the structure uniform. Therefore, the transfer method of the present invention enables the structure to be transferred to the transfer destination with high accuracy.

For example, the thermal decomposition of the resin layer at the interface is caused by a heat generation at a surface of the structure that is in contact with the resin layer to be a thermal decomposition temperature of the resin layer or higher by virtue of the transfer laser transmitted through the base member and the resin layer.

In the transfer method of the present invention, for example, the transfer laser transmitted through the base member and the resin layer enables the surface of the structure that is in contact with the resin layer to generate heat to be the thermal decomposition temperature of the resin layer or higher, thus causing the thermal decomposition of the resin layer and enabling the structure to be separated from the release plate.

It is preferable that a thermal decomposition temperature of a constitutional material of a surface of the structure that is in contact with the resin layer be higher than a thermal decomposition temperature of the resin layer.

When the thermal decomposition temperature of the constitutional material of the surface of the structure that is in contact with the resin layer is higher than the thermal decomposition temperature of the resin layer, the structure can be transferred while being prevented from deteriorating.

It is more preferable that the thermal decomposition temperature of the constitutional material of the surface of the structure that is in contact with the resin layer be higher than the thermal decomposition temperature of the resin layer by 200°C or more.

In such a case, it is possible to more reliably prevent the deterioration of the structure.

For example, it is possible that the resin layer contains dimethylpolysiloxane.

In the present invention, the constitutional material of the resin layer is not particularly limited, and it is possible that the resin layer contains, for example, dimethylpolysiloxane.

For example, it is possible that the surface of the structure that is in contact with the resin layer contains gallium nitride.

In the present invention, the constitutional material of the structure is not particularly limited and, for example, it is possible that the surface of the structure that is in contact with the resin layer contains gallium nitride (GaN).

For example, it is possible that the resin layer contains dimethylpolysiloxane, and the surface of the structure that is in contact with the resin layer contains gallium nitride.

For example, it is also possible that the resin layer contains dimethylpolysiloxane, while the surface of the structure that is in contact with the resin layer contains gallium nitride.

Alternatively, the resin layer may contain polyimide, and the surface of the structure that is in contact with the resin layer may contain gallium phosphide.

It is also possible that the resin layer contains polyimide, while the surface of the structure that is in contact with the resin layer contains gallium phosphide (GaP).

For example, the transfer laser may be an excimer laser having a wavelength of 248 nm.

For example, an excimer laser having a wavelength of 248 nm is usable as the transfer laser.

Furthermore, the present invention provides a transfer unit that transfers a structure to a transfer destination, the transfer unit comprising:
a light source configured to perform an oscillation of a transfer laser;
a release plate including a base member, a resin layer provided on the base member and having a transmittance of 90% or more for the transfer laser, and a structure held on a surface of the resin layer opposite the base member;
a holding mechanism configured to hold the transfer destination;
an alignment mechanism configured to cause the light source and the holding mechanism to face each other with the release plate therebetween; and
a controller configured to control the oscillation of the transfer laser by the light source so that the transfer laser enters the base member through a surface of the base member opposite the resin layer to thermally decompose at least a portion of the resin layer at an interface where the structure is in contact with the resin layer.

Such a transfer unit of the present invention makes it possible to reduce a change in the amount of gas generated during each transfer and within a laser-irradiated surface to make the flying-out direction and velocity of the structure uniform. Therefore, the transfer unit of the present invention enables the structure to be transferred to the transfer destination with high accuracy.

In the transfer unit, for example, at least the portion of the resin layer at the interface where the structure is in contact with the resin layer may be thermally decomposed to transfer the structure from the release plate to the transfer destination.

In the transfer unit of the present invention, it is possible that, for example, the thermal decomposition of at least the portion of the resin layer is caused at the interface where the structure is in contact with the resin layer to transfer the structure from the release plate to the transfer destination.

In the transfer unit, for example, the thermal decomposition of the resin layer at the interface may be caused by a heat generation at a surface of the structure that is in contact with the resin layer to be a thermal decomposition temperature of the resin layer or higher by virtue of the transfer laser transmitted through the base member and the resin layer.

In the transfer unit of the present invention, for example, the transfer laser transmitted through the base member and the resin layer enables the surface of the structure that is in contact with the resin layer to generate heat to be the thermal decomposition temperature of the resin layer or higher, thus causing the thermal decomposition of the resin layer at the interface and enabling the structure to be separated from the release plate.

It is preferable that a thermal decomposition temperature of a constitutional material of a surface of the structure that is in contact with the resin layer be higher than a thermal decomposition temperature of the resin layer.

When the thermal decomposition temperature of the constitutional material of the surface of the structure that is in contact with the resin layer is higher than the thermal decomposition temperature of the resin layer, the structure can be transferred while being prevented from deteriorating.

It is more preferable that the thermal decomposition temperature of the constitutional material of the surface of the structure that is in contact with the resin layer be higher than the thermal decomposition temperature of the resin layer by 200°C or more.

Such a transfer unit makes it possible to more reliably prevent the deterioration of the structure.

For example, the resin layer may contain dimethylpolysiloxane.

In the present invention, the constitutional material of the resin layer is not particularly limited, and it is possible that the resin layer contains, for example, dimethylpolysiloxane.

For example, it is possible that the surface of the structure that is in contact with the resin layer contains gallium nitride.

In the present invention, the constitutional material of the structure is not particularly limited and, for example, it is possible that the surface of the structure that is in contact with the resin layer contains gallium nitride (GaN).

For example, it is possible that the resin layer contains dimethylpolysiloxane, and the surface of the structure that is in contact with the resin layer contains gallium nitride.

For example, it is also possible that the resin layer contains dimethylpolysiloxane, while the surface of the structure that is in contact with the resin layer contains gallium nitride.

Alternatively, the resin layer may contain polyimide, and the surface of the structure that is in contact with the resin layer may contain gallium phosphide.

It is also possible that the resin layer contains polyimide, while the surface of the structure that is in contact with the resin layer contains gallium phosphide (GaP).

For example, the transfer laser may be an excimer laser having a wavelength of 248 nm.

For example, an excimer laser having a wavelength of 248 nm is usable as the transfer laser.

Furthermore, the present invention provides a method for manufacturing a display apparatus in which a structure is transferred to a wiring board, the method comprising:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

Such a method for manufacturing a display apparatus according to the present invention makes it possible to reduce a change in the amount of gas generated during each transfer and within a laser-irradiated surface to make the protruding direction and velocity of the structure uniform. Therefore, it is possible to manufacture a display apparatus in which structures are arranged on the wiring board with high accuracy.

Furthermore, the present invention provides a method for manufacturing a mounted board in which a structure is transferred to a wiring board, the method comprising:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

Such a method for manufacturing a mounted board according to the present invention makes it possible to reduce a change in the amount of gas generated during each transfer and within a laser-irradiated surface to make the protruding direction and velocity of the structure uniform. Therefore, it is possible to manufacture a mounted board in which structures are arranged on the wiring board with high accuracy.

### ADVANTAGEOUS EFFECTS OF INVENTION

As described above, the transfer method of the present invention makes it possible to transfer a structure to a transfer destination with high accuracy.

Furthermore, the transfer unit of the present invention makes it possible to transfer a structure to a transfer destination with high accuracy.

Furthermore, the method for manufacturing a display apparatus of the present invention makes it possible to manufacture a display apparatus in which structures are arranged on a wiring board with high accuracy.

Furthermore, the method for manufacturing a mounted board of the present invention makes it possible to manufacture a mounted board in which structures are arranged on a wiring board with high accuracy.

### BRIEF DESCRIPTION OF DRAWINGS

[FIG. 1] FIG. 1 is a schematic diagram illustrating an example of a transfer unit of the present invention;
[FIG. 2] FIG.2 is a schematic enlarged cross-sectional view of a portion of the release plate illustrated in FIG. 1;
[FIG. 3] FIG. 3 is a schematic enlarged cross-sectional view of a portion of an example of a transfer method of the present invention; and
[FIG. 4] FIG. 4 is a schematic cross-sectional view illustrating a portion of another example of the transfer method of the present invention.

### DESCRIPTION OF EMBODIMENTS

As described above, it has been demanded to develop a transfer method capable of transferring a structure to a transfer destination with high accuracy.

As a result of an intensive investigation on the above problem, the present inventors have found that a structure can be transferred to a transfer destination with high accuracy by using a release plate including a base member, a resin layer provided on the base member and having a transmittance of 90% or more for a transfer laser, and the structure held on a surface of the resin layer opposite the base member; and causing the transfer laser to enter the base member through a surface of the base member opposite the resin layer and thermally decomposing at least a portion of the resin layer at an interface where the structure is in contact with the resin layer by the entering transfer laser to transfer the structure from the release plate to the transfer destination, and have completed the present invention.

That is, the present invention is a transfer method for transferring a structure to a transfer destination, the transfer method including:
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the transfer destination.

Furthermore, the present invention is a transfer unit that transfers a structure to a transfer destination, the transfer unit including:
a light source configured to perform an oscillation of a transfer laser;
a release plate including a base member, a resin layer provided on the base member and having a transmittance of 90% or more for the transfer laser, and a structure held on a surface of the resin layer opposite the base member;
a holding mechanism configured to hold the transfer destination;
an alignment mechanism configured to cause the light source and the holding mechanism to face each other with the release plate therebetween; and
a controller configured to control the oscillation of the transfer laser by the light source so that the transfer laser enters the base member through a surface of the base member opposite the resin layer to thermally decompose at least a portion of the resin layer at an interface where the structure is in contact with the resin layer.

Furthermore, the present invention is a method for manufacturing a display apparatus in which a structure is transferred to a wiring board, the method including:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

Furthermore, the present invention is a method for manufacturing a mounted board in which a structure is transferred to a wiring board, the method including:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

Hereinafter, the present invention will be described in detail. However, the present invention is not limited thereto.

### [Transfer Unit]

A transfer unit of the present invention is a transfer unit that transfers a structure to a transfer destination, the transfer unit including:
a light source configured to perform an oscillation of a transfer laser;
a release plate including a base member, a resin layer provided on the base member and having a transmittance of 90% or more for the transfer laser, and a structure held on a surface of the resin layer opposite the base member;
a holding mechanism configured to hold the transfer destination;
an alignment mechanism configured to cause the light source and the holding mechanism to face each other with the release plate therebetween; and
a controller configured to control the oscillation of the transfer laser by the light source so that the transfer laser enters the base member through a surface of the base member opposite the resin layer to thermally decompose at least a portion of the resin layer at an interface where the structure is in contact with the resin layer.

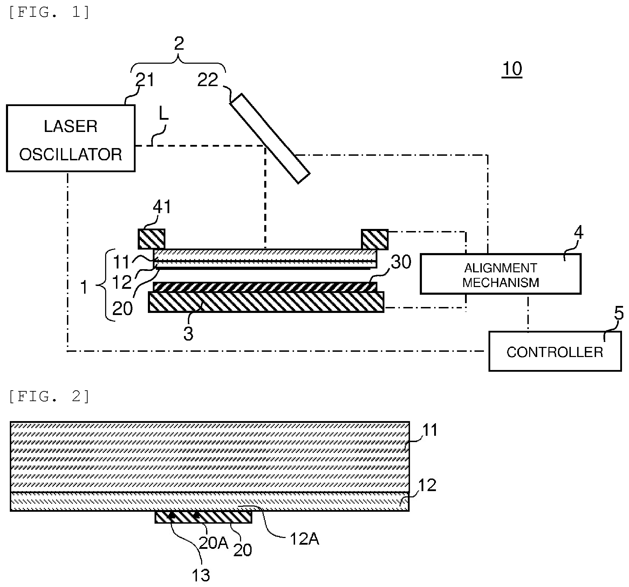

Description will be made below on an example of the transfer unit according to the present invention with reference to FIGS. 1 to 3. However, the transfer unit according to the present invention is not limited to the example illustrated in FIGS. 1 to 3.

A transfer unit 10 illustrated in FIG. 1 is a transfer unit that transfers a structure 20 to a transfer destination 30.

The transfer unit 10 illustrated in FIG. 1 includes a light source 2, a release plate 1, a holding mechanism 3, an alignment mechanism 4, and a controller 5.

The light source 2 is configured to perform an oscillation of a transfer laser L. The light source 2 includes a laser oscillator 21 that oscillates the transfer laser L and a mirror 22 that changes an orientation of the laser oscillator 21 in the example in FIG. 1; however, the light source 2 is not limited to have such a configuration. For example, the light source 2 may include a galvano scanner, which includes the mirror 22, a scanner that drives the mirror 22, and a controller that controls the mirror 22 and the scanner.

The laser oscillator 21 may be configured to pulse-oscillate the transfer laser L or may be configured to continuously oscillate the transfer laser L. The laser oscillator 21 configured to pulse-oscillate the transfer laser L is preferable, since it can irradiate only an appropriate portion with a transfer laser with an appropriate energy density.

The light source 2 may include, between the laser oscillator 21 and the release plate 1, a shaping optical system that shapes an energy distribution of the transfer laser L and/or a photomask that adjusts an irradiation pattern.

As described below in detail, a wavelength of the transfer laser L is not particularly limited as long as the wavelength is capable of thermally decomposing at least a portion of the resin layer at the interface where the structure is in contact with the resin layer. The transfer laser L may be, for example, an excimer laser (a KrF excimer laser) having a wavelength of 248 nm. Othe examples may include an ArF excimer laser (wavelength: 193 nm), a XeCl excimer laser (wavelength 308 nm), and a XeF excimer laser (wavelength: 353 nm). A KrF excimer laser is preferable in terms of usage record and ease of procurement.

FIG. 2 is a schematic enlarged cross-sectional view of a portion of the release plate 1 of the transfer unit 10 illustrated in FIG. 1.

The release plate 1 includes a base member 11, a resin layer 12 provided on the base member 11, and a structure 20 held on a surface of the resin layer 12 opposite the base member 11. In the example in FIG. 1, the release plate 1 includes a plurality of structures 20.

The base member 11 is not particularly limited and may be made of, for example, quartz. It is preferable that the base member 11 have a transmittance of 90% or more for the transfer laser L. However, as described later in detail, the transfer unit 10 of the present invention only has to be configured such that at least a portion 12A of the resin layer 12 is thermally decomposed at an interface 13 where the structure 20 is in contact with the resin layer 12 and, accordingly, the transmittance of the base member 11 for the transfer laser L is not particularly limited. When the base member 11 has a transmittance of 90% or more for the transfer laser L, attenuation of an energy of the transfer laser L from the light source 2 in the base member layer 11 can be reduced, enabling an energyefficient transfer.

A thickness of the base member 11 may be, for example, in a range from 0.1 mm to 1 mm, but is not particularly limited.

The resin layer 12 has a transmittance of 90% or more for the transfer laser L. Here, the transmittance refers to a transmittance reached when the transfer laser L is caused to vertically enter the surface of the resin layer 12, in other words, a transmittance in a thickness direction of the resin layer 12. This means that an absorptance of the resin layer 12 for the transfer laser L is less than 10%, which makes it possible to effectively reduce ablation of the resin layer 12. The transmittance of the resin layer 12 for the transfer laser L may depend on, for example, a material and a thickness of the resin layer 12 as well as the wavelength of the transfer laser L. The upper limit of the transmittance is 100%, but may be 98% or less, approximately, in terms of ease of procurement of the material.

The material of the resin layer 12 is not particularly limited and the resin layer 12 may include, for example, dimethylpolysiloxane, polyimide, benzocyclobutene resin, or a silicone resin.

The thickness of the resin layer 12 is not particularly limited, and may be set, for example, in a range from 0.005 mm to 1 mm.

Without wishing to be limited, the resin layer 12 containing dimethylpolysiloxane and having a thickness of 100 µm or less has a transmittance of 90% or more for the transfer laser L having a wavelength of 248 nm. Note that in a case where a transfer laser having a wavelength of other than 248 nm is used, the material contained in the resin layer and the thickness of the resin layer may be selected so that the transmittance for the transfer laser having that wavelength reaches 90% or more.

The structure 20 is an object to be transferred that is to be transferred to the transfer destination 30. The structure 20 is not particularly limited. For example, the structure 20 may be an LED chip such as a micro LED or a mini LED or may be a semiconductor chip.

A constitutional material of the structure 20 is not particularly limited and, for example, a surface 20A of the structure 20, which is in contact with the resin layer 12, may contain a gallium nitride (GaN) or gallium phosphide (GaP).

In the transfer unit 10 illustrated in FIG. 1, the release plate 1 is held by a holder 41.

The holding mechanism 3 is configured to hold the transfer destination 30.

The transfer destination 30 is not particularly limited as long as being able to receive the structure 20. In a case where the structure 20 is an LED chip, the transfer destination 30 may be a wiring board for a display apparatus. Alternatively, in a case where the structure 20 is a semiconductor chip, the transfer destination 30 may be a wiring board for a mounted board.

A detail of the holding mechanism 3 may be appropriately changed in accordance with the shape of the transfer destination 30, or the like. In the example in FIG. 1, the holding mechanism 3 is in the form of a stage on which the transfer destination 30 is placed and held.

The alignment mechanism 4 is configured to cause the light source 2 and the holding mechanism 3 to face each other with the release plate 1 therebetween. In the example of the transfer unit 10 illustrated in FIG. 1, the alignment mechanism 4 includes, without limitation, the holder 41 that holds the release plate 1, a mechanism (not illustrated) that positions each member of the light source 2, and a mechanism (not illustrated) that positions the holding mechanism 3.

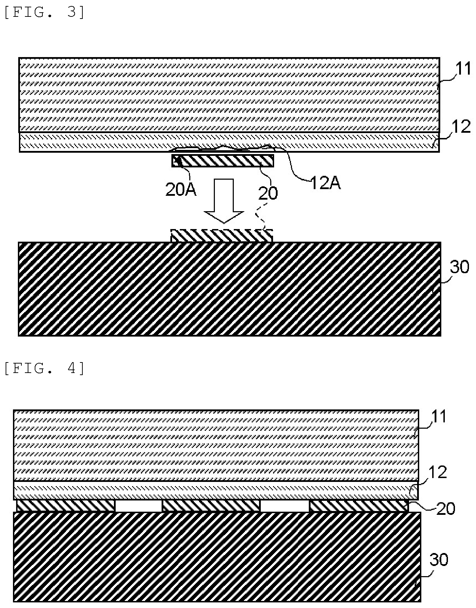

The controller 5 is configured to control the oscillation of the transfer laser L by the light source 2. In more detail, the controller 5 is configured to control the oscillation of the transfer laser L from the light source 2 so that the transfer laser L enters the base member 11 through the surface of the base member 11 opposite the resin layer 12 to thermally decompose at least the portion 12A of the resin layer 12 at the interface 13 where the structure 20 is in contact with the resin layer 12 as illustrated in, for example, FIG. 3.

Another detail of the transfer unit 10 will be described in a later section.

Using such a transfer unit 10 of the present invention makes it possible to perform a transfer method of the present invention described below in detail. Although a detailed reason will be described in "Transfer Method" below, using the transfer unit of the present invention can reduce a change in the amount of gas generated during each transfer and within a laser-irradiated surface even though a slight change in laser irradiation energy density distribution for each laser shot and a variation in energy density for each laser shot occur, which makes it possible to make the flying-out direction and velocity of the structure uniform. Therefore, the transfer method of the present invention enables the structure to be transferred to the transfer destination with high accuracy.

### [Transfer Method]

A transfer method for transferring a structure to a transfer destination, the transfer method including:
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the transfer destination.

Hereinafter, a transfer method using the transfer unit 10 illustrated in FIGS. 1 to 3 will be described as an example of the transfer method of the present invention. However, the transfer method of the present invention is not limited to the example described below, and may be performed in a unit or device other than the transfer unit 10 illustrated in FIGS. 1 to 3.

First, the release plate 1 described above is provided.

Subsequently, the transfer laser L is caused to enter the base member 11 through the surface of the base member 11 of the release plate 1 opposite the resin layer 12.

The transfer laser L may be oscillated from the light source 2. For example, the transfer laser L may be caused to enter the base member 11 after passing through a shaping optical system that shapes the energy distribution of the transfer laser L from the laser oscillator 21 and/or a photomask that adjusts the irradiation pattern of the transfer laser L from the laser oscillator 21.

Subsequently, the entering transfer laser L is transmitted through the base member 11 and the resin layer 12. Since the resin layer 12 has a transmittance of 90% or more for the transfer laser and thus has an absorptance of less than 10% for the transfer laser as described above, it is possible to reduce a rise in temperature and ablation due to the transmission of the laser beam.

The transfer laser L transmitted through the base member 11 and the resin layer 12 causes thermal decomposition of at least the portion 12A of the resin layer 12 at the interface 13 where the structure 20 is in contact with the resin layer 12 as illustrated in FIG. 3.

Without wishing to be bound by theory, the transfer laser L transmitted through the base member 11 and the resin layer 12 enters the surface 20A, which forms the interface 13 of the structure 20. The surface 20A of the structure 20 is able to generate heat when the transfer laser L enters the surface 20A. The surface 20A of the structure 20 is able to generate heat to be a thermal decomposition temperature of the resin layer 12 or higher. The thus-generated heat is transmitted to the resin layer 12. This causes the resin layer 12 to have a temperature gradient in which the temperature decreases with an increase in distance from the interface 13 side. The temperature of the portion 12A of the resin layer 12, which forms the interface 13, is then raised to a temperature at which thermal decomposition occurs. This results in thermal decomposition of the portion 12A. Accordingly, it is preferable that a portion of the structure 20 near the interface where the structure 20 is in contact with the resin layer 12 contain a material having a high absorptance for the transfer laser L.

The structure 20 can be separated from the release plate 1 by the thermal decomposition (ablation) of the portion 12A of the resin layer 12. The separated structure 20 can reach the transfer destination 30 as indicated by a dotted line in FIG. 3. Thus, the structure 20 is transferred to the transfer destination 30.

In conventional LIFT, a portion other than the portion 12A, which forms the interface 30, within the resin layer 12 is ablated by laser irradiation. The present inventors have found that the ablated position changes with a slight change in the laser irradiation energy density distribution for each pulse and a variation in energy density for each laser shot, resulting in a variation in the amount of gas generated during each transfer and within the laser-irradiated surface. The present inventors have then found that such a variation in the amount of the gas generated during each transfer and within the laser-irradiated surface has an influence even on the flying-out direction and velocity of the structure 20, thus becoming a bottleneck for improving transfer accuracy.

According to the transfer method of the present invention, the portion 12A, which forms the interface 30, in the resin layer 12 is thermally decomposed (ablated). Thus, even though a slight change in laser irradiation energy density distribution for each laser shot and a variation in energy density for each laser shot occur, it is possible to reduce a variation in the amount of gas generated during each transfer and in the laser-irradiated surface and, consequently, make the flying-out direction and velocity of the structure 20 uniform to improve transfer accuracy.

That is to say, the transfer method of the present invention enables the structure 20 to be transferred to the transfer destination 30 with high accuracy.

Furthermore, unlike the related art, the transfer method of the present invention does not utilize active ablation of the resin layer 12, but rather utilize thermal decomposition at the interface 30. This make it possible to employ a highly transparent material that has a high transmittance for the transfer laser and is difficult to use in LIFT utilizing ablation. That is, it is possible to effectively perform LIFT using a resin layer that includes a material, which is typified by dimethylpolysiloxane or the like, and having a transmittance of 90% or more for the transfer laser.

Furthermore, unlike LIFT in which only a difference in thermal expansion between the structure 12 and the resin layer 12 is utilized, the transfer method of the present invention involves thermal decomposition of the resin layer 12, which enables an improvement in transfer accuracy.

Hereinafter, description will be made on optional features of the transfer method and the transfer unit of the present invention.

For example, in the present invention, the thermal decomposition of the resin layer 12 can be caused at the interface 13 when the transfer laser L transmitted through the base member 11 and the resin layer 12 causes the surface 20A of the structure 20, which is in contact with the resin layer 12, to generate heat to be the thermal decomposition temperature of the resin layer 12 or higher.

When a thermal decomposition temperature of a constitutional material of the surface 20A of the structure 20, which is in contact with the resin layer 12, is higher than the thermal decomposition temperature of the resin layer 12, it is possible to perform transfer while preventing the deterioration of the structure 20.

In particular, when the thermal decomposition temperature of the constitutional material of the surface 20A of the structure 20, which is in contact with the resin layer 12, is higher than the thermal decomposition temperature of the resin layer 12 by 200°C or more, it is possible to more reliably prevent the deterioration of the structure 20. An upper limit of a difference in thermal decomposition temperature is not particularly limited and may be, for example, 500°C, approximately.

Note that in a case where the surface 20A of the structure 20, which is in contact with the resin layer 12, is thermally decomposed to form a thin film that is easy to remove, the surface 20A of the structure 20, which is in contact with the resin layer 12, may be caused to generate heat to be the thermal decomposition temperature or higher. For example, in a case where gallium nitride is the material of the structure 20, a gallium metal film is generated as a result of significant thermal decomposition caused by generation of heat to be a temperature of 900°C or higher, so that the gallium metal film may be removed by an acidic aqueous solution such as hydrochloric acid. Note that not only the above acidic aqueous solution but also an alkaline aqueous solution is usable for removal in accordance with the solubility of the generated thin film. In this manner, restrictions on the material used for the structure 20 and the material used for the resin layer 12 can be reduced, thereby allowing a larger number of combinations to be employed.

For example, the resin layer 12 may contain dimethylpolysiloxane, and the surface 20A of the structure 20, which is in contact with the resin layer 12, may contain gallium nitride or gallium phosphide.

Such a combination of materials is suitable for a case where the wavelength of the transfer laser L is 248 nm.

In another aspect, for example, the resin layer 12 may contain polyimide or benzocyclobutene resin and the surface 20A of the structure 20, which is in contact with the resin layer 12, may contain gallium nitride or gallium phosphide.

An output of the transfer laser L may be selected as appropriate.

Note that FIGS. 1 to 3 illustrate the example in which the release plate 1 and the transfer destination 30 are spaced with a gap in between, that is, gap LIFT. In conventional gap LIFT, a deterioration in transfer position accuracy due to the described-above variation in the amount of gas generated within the laser-irradiated surface is significant. In contrast, the transfer method and the transfer unit of the present invention make it possible to reduce even a variation in the amount of gas generated within the laser-irradiated surface, so that the structure 20 can be transferred with high accuracy even though the gap is, for example, 300 µm.

Alternatively, in the transfer method and the transfer unit 1 of the present invention, the release plate 1 and the transfer destination 30 may be arranged with the structure 20 being in contact with the transfer destination 30 as illustrated in, for example, FIG. 4. LIFT performed in such a state may be referred to as, for example, contact LIFT. In the case where contact LIFT is performed as the transfer method of the present invention , it is possible to transfer the structure 20 with even higher accuracy.

Note that the transfer method of the present invention makes it possible to minimize ablation of the resin layer 12 as compared with the prior art. In other words, the thermal decomposition of the resin layer 12 can be concentrated near the interface with the structure 20. This facilitates reducing, in the transfer destination 30, residues and carbon debris originating from the resin layer 12. Therefore, even in a case where high-accuracy transfer is not required or in a case where a higher accuracy is to be achieved by another means, the present invention is employable for the purpose of reducing the generation of residues and carbon debris originating from the resin layer 12. Furthermore, in a case where the structure 20 is in the form of an LED chip and a surface of the LED chip to be brought into contact with the resin layer 12 is a lightemitting surface, it is important to reduce the generation of the above residues and carbon debris.

Furthermore, as long as the thermal decomposition of the resin layer 12 can be concentrated near the interface with the structure 20, the transmittance of the resin layer for the transfer laser does not have to be 90% or more and may be less than 90%. In this case, a reduction in ablation can be expected by thinning the resin layer to reduce ablation of the resin layer due to absorption of the transfer laser or adjusting the irradiation dose of the transfer laser.

### [Method for Manufacturing Display Apparatus and Method for Manufacturing Mounted Board]

A method for manufacturing a display apparatus according to the present invention is a method for manufacturing a display apparatus in which a structure is transferred to a wiring board, the method including:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

In other words, the method for manufacturing a display apparatus of the present invention can also be referred to as a manufacturing method including a transferring method of the present invention in which a transfer destination is a wiring board and a structure is to be transferred to the wiring board.

For the reason described above, such a method for manufacturing a display apparatus according to the present invention makes it possible to reduce a change in the amount of gas generated during each transfer and within the laser-irradiated surface to make the flying-out direction and velocity of the structure uniform. Therefore, it is possible to manufacture a display apparatus in which the structures are arranged on the wiring board with high accuracy.

Furthermore, a method for manufacturing a mounted board according to the present invention is a method for manufacturing a mounted board in which a structure is transferred to a wiring board, the method including:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

In other words, the method for manufacturing a mounted board according to the present invention can also be referred to as a manufacturing method including the transfer method of the present invention in which a transfer destination is a wiring board and a structure is to be transferred to the wiring board.

For the reason described above, such a method for manufacturing a mounted board according to the present invention makes it possible to reduce a change in the amount of gas generated during each transfer and within the laser-irradiated surface to make the flying-out direction and velocity of the structure uniform. Therefore, it is possible to manufacture a mounted board in which the structures are arranged on the wiring board with high accuracy.

### EXAMPLES

Hereinafter, the present invention will be specifically described with reference to Example and Comparative Example, but the present invention is not limited thereto.

### (Example)

In Examples, the transfer unit 10 illustrated in FIGS. 1 to 3 was used to transfer the structures 20 by gap LIFT.

A release plate including the base member 11 made of quartz, the resin layer 12 including
dimethylpolysiloxane, and twenty micro-LED chips 20 held on the surface of the base member 11 opposite the resin layer 12 was provided as the release plate 1. The surface 20A of each of the micro-LED chips 20, which was in contact with the resin layer 12, contained gallium nitride.

A light source including the laser oscillator 21 capable of oscillating, as the transfer laser L, a pulsed excimer laser with a wavelength of 248 nm was provided as the light source 2.

A donor plate in which a silicone resin layer was formed on a surface of a base member made of quartz was provided as the transfer destination 30.

A transmittance of the resin layer 12 for the transfer laser L was 90% or more.

In the thus-provided transfer unit, the transfer laser L was caused to enter the base member 11 through the surface of the base member 11 opposite the resin layer 12 using the alignment mechanism 4 and the controller 5. Then, the output of the transfer laser L was controlled so that the transfer laser L was transmitted through the base member 11 and the resin layer 12 to thermally decompose the portion 12 of the resin layer 12 at the interface 13 at which each of the micro-LED chips 20 was in contact with the resin layer 12. The micro-LED chips 20 were each transferred from the release plate 1 to the transfer destination 30 in this manner.

In this Example, it was possible to perform transfer to a target position with accuracy. Furthermore, by observing the release plate 1 of Example after the transfer, it was found that the resin layer 12 decomposed only near the surface where each of the micro-LED chips 20 had been held.

From these results, it is considered that in Example, since decomposition of the resin layer 12 only near the surface where each of the micro-LED chips 20 was held was achieved during each transfer, thereby making it possible to reduce a change in the amount of gas generated during each transfer and within the laser-irradiated surface to make the flying-out direction and velocity of each of the micro-LED chips 20 uniform, and thus it was possible to transfer each of the micro-LED chips 20 to the transfer destination 30 with high accuracy.

### (Comparative Example)

Transfer was performed in a similar manner to that in Example except that the output of the transfer laser L was controlled so as not to cause the portion 12 of the resin layer 12 to thermally decompose at the interface 13 where each of the micro-LED chips 20 was in contact with the resin layer 12 when the transfer laser L was transmitted through the base member 11 and the resin layer 12.

As compared with Example, some of the micro-LED chips 20 failed to be transferred to desired positions in this Comparative Example. Furthermore, by observing the release plate of Comparative Example after the transfer, thermal decomposition of the resin layer 12 near the surface where the micro-LED chips 20 had been held was not found. A reason why Comparative Example was inferior in transfer accuracy to Example may be that separation was performed by virtue of using only a difference in thermal expansion between the structure and the resin layer, making a misalignment in an inplane direction likely to occur.

The present description includes the following embodiments.
[1] A transfer method for transferring a structure to a transfer destination, the transfer method comprising:
   providing a release plate, the release plate including a base member, a resin layer provided on the base member and having a transmittance of 90% or more for a transfer laser, and a structure held on a surface of the resin layer opposite the base member;
   causing the transfer laser to enter the base member through a surface of the base member opposite the resin layer; and
   causing the transfer laser which entered to be transmitted through the base member and the resin layer and to thermally decompose at least a portion of the resin layer at an interface where the structure is in contact with the resin layer, thereby transferring the structure from the release plate to the transfer destination.
[2] The transfer method according to [1], wherein the thermal decomposition of the resin layer at the interface is caused by a heat generation at a surface of the structure that is in contact with the resin layer to be a thermal decomposition temperature of the resin layer or higher by virtue of the transfer laser transmitted through the base member and the resin layer.
[3] The transfer method according to [1] or [2], wherein a thermal decomposition temperature of a constitutional material of a surface of the structure that is in contact with the resin layer is higher than a thermal decomposition temperature of the resin layer.
[4] The transfer method according to [3], wherein the thermal decomposition temperature of the constitutional material of the surface of the structure that is in contact with the resin layer is higher than the thermal decomposition temperature of the resin layer by 200°C or more.
[5] The transfer method according to any one of [1] to [4], wherein the resin layer contains dimethylpolysiloxane.
[6] The transfer method according to any one of [1] to [5], wherein a surface of the structure that is in contact with the resin layer contains gallium nitride.
[7] The transfer method according to any one of [1] to [6], wherein the resin layer contains dimethylpolysiloxane, and the surface of the structure that is in contact with the resin layer contains gallium nitride.
[8] The transfer method according to any one of [1] to [6], wherein the resin layer contains polyimide and the surface of the structure that is in contact with the resin layer contains gallium phosphide.
[9] The transfer method according to any one of [1] to [8], wherein the transfer laser is an excimer laser having a wavelength of 248 nm.
[10] A transfer unit that transfers a structure to a transfer destination, the transfer unit comprising:
   a light source configured to perform an oscillation of a transfer laser;
   a release plate including a base member, a resin layer provided on the base member and having a transmittance of 90% or more for the transfer laser, and a structure held on a surface of the resin layer opposite the base member;
   a holding mechanism configured to hold the transfer destination;
   an alignment mechanism configured to cause the light source and the holding mechanism to face each other with the release plate therebetween; and
   a controller configured to control the oscillation of the transfer laser by the light source so that the transfer laser enters the base member through a surface of the base member opposite the resin layer to thermally decompose at least a portion of the resin layer at an interface where the structure is in contact with the resin layer.
[11] The transfer unit according to [10], wherein at least the portion of the resin layer at the interface where the structure is in contact with the resin layer is thermally decomposed to transfer the structure from the release plate to the transfer destination.
[12] The transfer unit according to [11], wherein the thermal decomposition of the resin layer at the interface is caused by a heat generation at a surface of the structure that is in contact with the resin layer to be a thermal decomposition temperature of the resin layer or higher by virtue of the transfer laser transmitted through the base member and the resin layer.
[13] The transfer unit according to [10] or [11], wherein a thermal decomposition temperature of a constitutional material of a surface of the structure that is in contact with the resin layer is higher than a thermal decomposition temperature of the resin layer.
[14] The transfer unit according to [13], wherein the thermal decomposition temperature of the constitutional material of the surface of the structure that is in contact with the resin layer is higher than the thermal decomposition temperature of the resin layer by 200°C or more.
[15] The transfer unit according to any one of [10] to [14], wherein the resin layer contains dimethylpolysiloxane.
[16] The transfer unit according to any one of [10] to [15], wherein a surface of the structure that is in contact with the resin layer contains gallium nitride.
[17] The transfer unit according to any one of [10] to [16], wherein the resin layer contains dimethylpolysiloxane, and the surface of the structure that is in contact with the resin layer contains gallium nitride.
[18] The transfer unit according to any one of [10] to [16], wherein the resin layer contains polyimide and the surface of the structure that is in contact with the resin layer contains gallium phosphide.
[19] The transfer unit according to any one of [10] to [18], wherein the light source is configured to perform an oscillation of an excimer laser having a wavelength of 248 nm.
[20] A method for manufacturing a display apparatus in which a structure is transferred to a wiring board, the method comprising:
   providing the wiring board;
   providing a release plate, the release plate including a base member, a resin layer provided on the base member and having a transmittance of 90% or more for a transfer laser, and a structure held on a surface of the resin layer opposite the base member;
   causing the transfer laser to enter the base member through a surface of the base member opposite the resin layer; and
   causing the transfer laser which entered to be transmitted through the base member and the resin layer and to thermally decompose at least a portion of the resin layer at an interface where the structure is in contact with the resin layer, thereby transferring the structure from the release plate to the wiring board.
[21] A method for manufacturing a mounted board in which a structure is transferred to a wiring board, the method comprising:
   providing the wiring board;
   providing a release plate, the release plate including a base member, a resin layer provided on the base member and having a transmittance of 90% or more for a transfer laser, and a structure held on a surface of the resin layer opposite the base member;
   causing the transfer laser to enter the base member through a surface of the base member opposite the resin layer; and
   causing the transfer laser which entered to be transmitted through the base member and the resin layer and to thermally decompose at least a portion of the resin layer at an interface where the structure is in contact with the resin layer, thereby transferring the structure from the release plate to the wiring board.

Note that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A transfer method for transferring a structure to a transfer destination, the transfer method comprising:
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the transfer destination.

2. The transfer method according to claim 1, wherein the thermal decomposition of the resin layer at the interface is caused by a heat generation at a surface of the structure that is in contact with the resin layer to be a thermal decomposition temperature of the resin layer or higher by virtue of the transfer laser transmitted through the base member and the resin layer.

3. The transfer method according to claim 1 or 2, wherein a thermal decomposition temperature of a constitutional material of a surface of the structure that is in contact with the resin layer is higher than a thermal decomposition temperature of the resin layer.

4. The transfer method according to claim 3, wherein the thermal decomposition temperature of the constitutional material of the surface of the structure that is in contact with the resin layer is higher than the thermal decomposition temperature of the resin layer by 200°C or more.

5. The transfer method according to claim 1 or 2, wherein the resin layer contains dimethylpolysiloxane.

6. The transfer method according to claim 1 or 2, wherein a surface of the structure that is in contact with the resin layer contains gallium nitride.

7. The transfer method according to claim 3, wherein the resin layer contains dimethylpolysiloxane, and the surface of the structure that is in contact with the resin layer contains gallium nitride.

8. The transfer method according to claim 3, wherein the resin layer contains polyimide and the surface of the structure that is in contact with the resin layer contains gallium phosphide.

9. The transfer method according to claim 1 or 2, wherein the transfer laser is an excimer laser having a wavelength of 248 nm.

10. A transfer unit that transfers a structure to a transfer destination, the transfer unit comprising:
a light source configured to perform an oscillation of a transfer laser;
a release plate including a base member, a resin layer provided on the base member and having a transmittance of 90% or more for the transfer laser, and a structure held on a surface of the resin layer opposite the base member;
a holding mechanism configured to hold the transfer destination;
an alignment mechanism configured to cause the light source and the holding mechanism to face each other with the release plate therebetween; and
a controller configured to control the oscillation of the transfer laser by the light source so that the transfer laser enters the base member through a surface of the base member opposite the resin layer to thermally decompose at least a portion of the resin layer at an interface where the structure is in contact with the resin layer.

11. The transfer unit according to claim 10, wherein at least the portion of the resin layer at the interface where the structure is in contact with the resin layer is thermally decomposed to transfer the structure from the release plate to the transfer destination.

12. The transfer unit according to claim 11, wherein the thermal decomposition of the resin layer at the interface is caused by a heat generation at a surface of the structure that is in contact with the resin layer to be a thermal decomposition temperature of the resin layer or higher by virtue of the transfer laser transmitted through the base member and the resin layer.

13. The transfer unit according to claim 10 or 11, wherein a thermal decomposition temperature of a constitutional material of a surface of the structure that is in contact with the resin layer is higher than a thermal decomposition temperature of the resin layer.

14. The transfer unit according to claim 13, wherein the thermal decomposition temperature of the constitutional material of the surface of the structure that is in contact with the resin layer is higher than the thermal decomposition temperature of the resin layer by 200°C or more.

15. The transfer unit according to claim 10 or 11, wherein the resin layer contains dimethylpolysiloxane.

16. The transfer unit according to claim 10 or 11, wherein a surface of the structure that is in contact with the resin layer contains gallium nitride.

17. The transfer unit according to claim 13, wherein the resin layer contains dimethylpolysiloxane, and the surface of the structure that is in contact with the resin layer contains gallium nitride.

18. The transfer unit according to claim 13, wherein the resin layer contains polyimide and the surface of the structure that is in contact with the resin layer contains gallium phosphide.

19. The transfer unit according to claim 10 or 11, wherein the light source is configured to perform an oscillation of an excimer laser having a wavelength of 248 nm.

20. A method for manufacturing a display apparatus in which a structure is transferred to a wiring board, the method comprising:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.

21. A method for manufacturing a mounted board in which a structure is transferred to a wiring board, the method comprising:
providing the wiring board;
providing a release plate, the release plate including a base member, a resin layer provided on the base member and having a transmittance of 90% or more for a transfer laser, and a structure held on a surface of the resin layer opposite the base member;
causing the transfer laser to enter the base member through a surface of the base member opposite the resin layer; and
causing the transfer laser which entered to be transmitted through the base member and the resin layer and to thermally decompose at least a portion of the resin layer at an interface where the structure is in contact with the resin layer, thereby transferring the structure from the release plate to the wiring board.
